# EUROPÄISCHE PATENTANMELDUNG

(11) **EP 1 530 054 A1**
(43) Veröffentlichungstag der Anmeldung: **11.05.2005**
(21) Anmeldenummer: 04021405.8
(22) Anmeldetag: 09.09.2004
(51) Int. Cl.: G01R 31/28

(54) **Prüfgerät zum Prüfen der Funktionsfähigkeit einer elektrischen Komponente**

(30) Priorität: 08.11.2003 DE 10352282
(71) Anmelder: ROBERT BOSCH GMBH, 70442 Stuttgart (DE)
(72) Erfinder: Dittmann, Karl-Heinz, 73054 Eislingen (DE); Zauner, Friedrich, 73107 Eschenbach (DE); Gern, Christian, 73249 Wernau/N (DE); Haaga, Gerhard, 73275 Ohmden (DE); Schulz, Claus, 68782 Bruehl (DE)

(57) **Zusammenfassung**

Die Erfindung betrifft ein Prüfgerät (200), insbesondere für Kfz-Werkstätten zum Prüfen der Funktionsfähigkeit einer Komponente eines Kfz. Bekannte Prüfgeräte dieser Art sind in ihren Prüfmöglichkeiten begrenzt. Um versteckte beziehungsweise schwierig zu findende Fehler in der Komponente dennoch finden zu können, weist das Prüfgerät einen Signalgenerator (210) zum Bereitstellen von mindestens einem Prüfsignal als Eingangssignal für die zu prüfende Komponente und/oder eine vorzugsweise variabel einstellbare Impedanz zum elektrischen Belasten der zu prüfenden Komponente auf.

## Beschreibung

Die Erfindung betrifft ein Prüfgerät, insbesondere für Kfz-Werkstätten zum Prüfen der Funktionsfähigkeit einer insbesondere elektrischen Komponente eines Kfz.

### Stand der Technik

Derartige Prüfgeräte sind im Stand der Technik grundsätzlich bekannt. Beispiele für solche Prüfgeräte in Form von Diagnosegeräten sind die Geräte Scandiag X8000 der Firma Facom und KTS 650 der Firma Robert Bosch GmbH. Es ist vorgesehen zum Anschluss an ein Steuergerät eines Kraftfahrzeugs und zum Auslesen eines von.dem Steuergerät erstellten Fehlerprotokolles. Aufgrund des Fehlerprotokolles können dann Hinweis auf defekte elektrische Komponenten oder sogar auf konkrete Defekte in einzelnen der Komponenten gewonnen werden.

Eine weitere gebräuchliche Vorgehensweise zum Detektieren defekter elektronischer Komponenten in einem Kraftfahrzeug besteht darin, das Fahrzeug und insbesondere den elektronischen Schaltkreis, in welchem die defekte elektronische Komponente vermutet wird, wie üblich in Betrieb zu nehmen und dabei an geeigneten Stellen in dem Schaltkreis auftretenden elektrischen Signale zu messen und auszuwerten. Die beschriebenen bekannten Vorgehensweise sind jedoch nicht immer zielführend. Insbesondere versteckte oder schwierig zu detektierende Fehler lassen sich damit oftmals nicht genau lokalisieren.

Ausgehend von diesem Stand der Technik ist es deshalb die Aufgabe der Erfindung, ein Prüfgerät zum Prüfen der Funktionsfähigkeit einer insbesondere elektrischen Komponente eines Kraftfahrzeugs bereitzustellen, welches eine verbesserte und sehr zielgenaue Prüfung der Komponente gestattet.

Diese Aufgabe wird durch den in Patentanspruch 1 beanspruchten Gegenstand gelöst. Bei diesem Gegenstand handelt es sich um ein Prüfgerät, welches gekennzeichnet ist durch einen Signalgenerator zum Bereitstellen von mindestens einem Prüfsignal als Eingangssignal für die zu prüfende Komponente und/oder eine vorzugsweise variabel einstellbare Impedanz zum Belasten der zu prüfenden Komponente.

### Vorteile der Erfindung

Bei dem beanspruchten Prüfgerät handelt es sich um ein aktives Prüfgerät, weil es aktiv ein Prüfsignal bereitstellt. Der insbesondere elektrische Schaltkreis, in welchem die zu prüfende insbesondere elektrische Komponente eingebaut ist, kann nun an geeigneter Stelle aufgetrennt werden, um das generierte Prüfsignal dort einzuspeisen. Die Reaktion der Komponenten in dem Teil des Schaltkreises, in welchen das Prüfsignal eingespeist wurde, auf das Prüfsignal kann dann beobachtet und mit einer erwarteten Reaktion verglichen werden. Das Ergebnis dieses Vergleiches gestattet vorteilhafterweise eine Aussage über die Funktionsfähigkeit von sowohl den Komponenten in dem Teil des Schaltkreises, in den das Prüfsignal eingespeist wurde, wie auch über die Funktionsfähigkeit der Komponenten in dem abgetrennten Teil des ursprünglichen elektrischen Schaltkreises, welcher nicht mit dem Prüfsignal beaufschlagt wurde.

Für die Verwendung des Prüfgerätes beziehungsweise die Durchführung der beschriebenen Vorgehensweise ist es vorteilhafterweise in der Regel nicht erforderlich, dass die zu überprüfende elektrische Komponente aus dem Kraftfahrzeug ausgebaut werden muss. Vielmehr ist es ausreichend, wenn lediglich eine in der Regel vorhandene Steckverbindung an geeigneter Stelle gelöst wird, um dort das Prüfsignal einzuspeisen. Ein weiterer Vorteil ist darin zu sehen, dass mit der beschriebenen Vorgehensweise gleichzeitig auch die Funktionsfähigkeit von Kabelverbindungen oder Anschlusssteckern als Bestandteil des besagten elektrischen Schaltkreises gleichzeitig mit überprüft werden können. Fehler in Kabelverbindungen lassen sich zum Beispiel dann leicht feststellen, wenn während der Prüfung an der Kabelverbindung gewackelt wird.

Alternativ oder ergänzend zur Einspeisung des Prüfsignals kann eine zu überprüfende elektronische Komponente auch dadurch getestet werden, indem sie mit einer von dem Prüfgerät bereitgestellten Impedanz belastet wird. Vorteilhafterweise ist diese Impedanz variabel einstellbar und insofern an den Ausgang der zu prüfenden elektrischen Komponente anpassbar. Auch in diesem Fall ist dann wieder das Verhalten der elektrischen Komponente im Belastungsfall mit ihrem Verhalten in nicht belastetem Zustand zu vergleichen, um aus dem Ergebnis dieses Vergleiches Rückschlüsse auf ihre Fehlerhaftigkeit zu ziehen.

Vorteilhafterweise ist der Signalgenerator ausgebildet, das Prüfsignal als typisches Eingangssignal für die zu prüfende Komponente in einem vorbestimmten Betriebszustand auszubilden. Dabei handelt es sich vorzugsweise um denjenigen Betriebszustand, in welchem ein Fehlverhalten der Komponente vermutet wird.

Es ist insbesondere von Vorteil, wenn der Signalgenerator ausgebildet ist, das Prüfsignal so auszubilden, dass es dem Ausgangssignal einer der zu prüfenden Komponente üblicherweise vorgeschalteten Komponente entspricht beziehungsweise diese repräsentiert. Auf diese Weise kann bei Einspeisung des Prüfsignals am Eingang der zu prüfenden Komponente die vorgeschaltete Komponente zu Testzwecken simuliert werden.

Vorteilhafterweise umfasst das Prüfgerät eine Speichereinrichtung zum Speichern beziehungsweise gegebenenfalls zum Bereitstellen beziehungsweise Simulieren von mindestens jeweils einem Ausgangsignal für eine Vielzahl unterschiedlicher, insbesondere elektrischer Komponenten.

Es ist weiterhin von Vorteil, wenn der Signalgenerator eine Schnittstelle oder einen Messkanaleingang aufweist zum Erfassen eines extern bereitgestellten Soll-Signals und ausgebildet ist zum Speichern des Soll-Signals in der Speichereinrichtung und zum Ausgeben des Soll-Signals als das Prüfsignal. Bei den Soll-Signalen handelt es sich insbesondere um die ordnungsgemäßen Ausgangsignale der unterschiedlichen Komponenten in verschiedenen Betriebssituationen.

Das Prüfsignal beziehungsweise das Soll-Signal kann jedoch auch bewusst als Fehlersignal in Form eines atypischen Eingangssignals für die zu prüfende elektrische Komponente ausgebildet sein. In diesem Fall wird dann kein ordnungsgemäßes Verhalten, sondern ein bestimmtes fehlerhaftes Verhalten der zu prüfenden Komponente erwartet, wenn diese ordnungsgemäß arbeitet.

Vorteilhafterweise ist der Signalgenerator ausgebildet, das Prüfsignal in seiner Signalform zu variieren, um auf diese Weise das Verhalten der zu prüfenden insbesondere elektrischen Komponente bei unterschiedlichen Signalformen zu überprüfen. Durch die Variation des Prüfsignals während der Prüfung können vorteilhafterweise verschiedene Betriebszustände der abgekoppelten Komponente simuliert werden, so dass auch versteckte Fehler, die nur in bestimmten Betriebssituation auftreten, durch Modulation des Prüfsignals detektiert werden können.

Vorteilhafterweise ist der Signalgenerator kurzschlussfest ausgebildet und weist eine Begrenzungsmöglichkeit für seinen Ausgangsstrom auf.

Um auch das Prüfen von insbesondere elektrischen Komponenten mit hoher Leistungsaufnahme zu ermöglichen, wird dem Signalgenerator optional ein Powergenerator nachgeschaltet, zum Bereitstellen des Prüfsignals mit einer an den Bedarf der zu prüfenden elektrischen Komponente angepassten Höhe des Ausgangsstromes.

Es ist von Vorteil, dass die zu prüfende Komponente keine elektrische Komponente und das Prüfsignal kein elektrisches Prüfsignal zu sein braucht. Vielmehr kann sowohl die Komponente wie auch das Prüfsignal anderer physikalischer Natur sein.

Schließlich ist es von Vorteil, wenn das erfindungsgemäße Prüfgerät eine Mess- und/oder Anzeigeeinrichtung, insbesondere in Form eines Oszilloskops aufweist. Das Oszilloskop kann zum einen zum Anzeigen des von dem Signalgenerator generierten Prüfsignals dienen. Alternativ oder - bei Ausbildung als mehrkanaliges Oszilloskop - kann das Oszilloskop zusätzlich auch dazu verwendet werden, das Ausgangssignal von insbesondere der zu prüfenden elektrischen Komponente zu erfassen, zu messen und/oder anzuzeigen.

Weitere vorteilhafte Ausgestaltungen des Prüfgerätes und insbesondere des Prüfsignals sind Gegenstand der abhängigen Ansprüche.

### Zeichnungen

Der Beschreibung sind zwei Figuren beigefügt, wobei
- Figur 1: einen typischen elektrischen Schaltkreis mit zu überprüfenden elektrischen Komponenten;
- Figur 2: den Aufbau des erfindungsgemäßen Prüfgerätes; und
- Figur 3a: eine zu prüfende elektrische Komponente; und
- Figur 3b: einen erfassten Signalverlauf für die elektrische Komponente nach Figur 3a
zeigt.

### Beschreibung der Ausführungsbeispiele

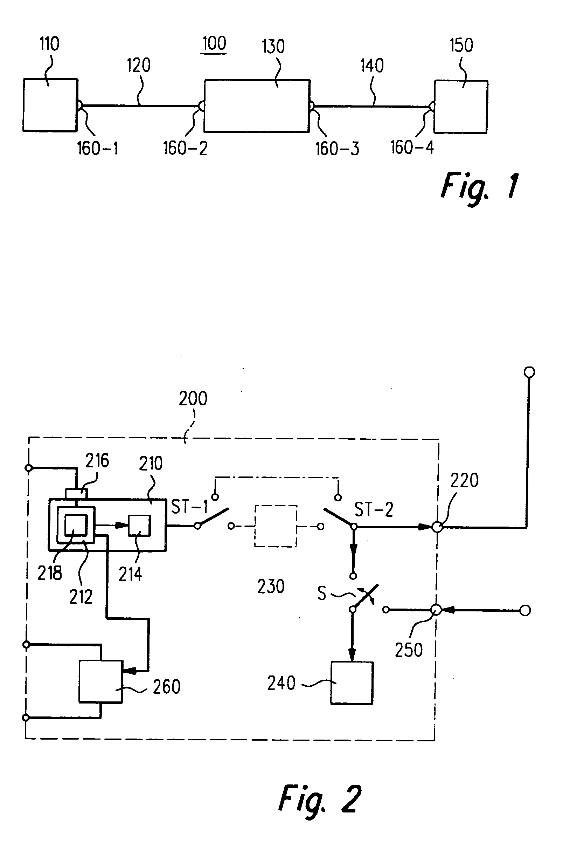

Figur 1 veranschaulicht den typischen Aufbau eines elektronischen Schaltkreises in Form einer Messkette, wie er in vielfältiger Weise in einem Kraftfahrzeug typischerweise eingebaut ist. Der Schaltkreis 100 umfasst zum einen eine Sensoreinrichtung 110 zum Erfassen eine physikalischen Größe und zum Generieren eines Messsignals als Ausgangssignal, welches den zeitlichen Verlauf beziehungsweise die Veränderung der erfassten Messgröße repräsentiert. Über eine erste Kabelverbindung 120 wird das Messsignal als Eingangssignal an ein Steuergerät 130 des Kraftfahrzeugs geliefert. Das Steuergerät erfasst das Messsignal, wertet es aus und generiert an seinem Ausgang ein Stellsignal zum Ansteuern eines dem Steuergerät nachgeschalteten Stellgliedes 150. Die Übertragung des Stellsignals erfolgt über eine zweite Kabelverbindung 140. Sowohl die erste wie auch die zweite Kabelverbindung sind vorzugsweise über lösbare Steckverbindungen 160-1...-4 an die jeweiligen Komponenten 110 - 150 angeschlossen.

In Figur 2 ist der Aufbau des erfindungsgemäßen Prüfgerätes 200 veranschaulicht. Es umfasst einen Signalgenerator 210 zum Bereitstellen von mindestens einem Prüfsignal als Ausgangssignal für das Prüfgerät 200 und als Eingangssignal für eine zu prüfende elektrische Komponente des in Figur 1 dargestellten Schaltkreises. Optional kann zwischen den Ausgang 220 des Prüfgerätes 200 und den Ausgang des Signalgenerators 210 über eine Steckverbindung St-1, St-2 ein sogenannter Power-Generator 230 geschaltet sein, welcher das von dem Signalgenerator bereitgestellte Prüfsignal an die Leistungsaufnahme von insbesondere den zu prüfenden elektrischen Komponenten 110, 130 oder 150 durch geeignete Anpassung der Höhe des Ausgangsstroms des Prüfgerätes 200 anpasst. Ebenfalls optional umfasst das Prüfgerät 200 eine Mess- und Anzeigeeinrichtung 240, vorzugsweise ein Oszilloskop. Sie dient einerseits zum Anzeigen des von dem Signalgenerator 210 generierten Prüfsignals und/oder zum Erfassen und Auswerten einer über einen Eingang 250 des Prüfgerätes 200 empfangene Ausgangsspannung der zu prüfenden elektrischen Komponente 110, 130 oder 150; die Auswahl erfolgt über einen Schalter S.

Der Signalgenerator 200 wird vorzugsweise mit einem schnellen Digital/Analog-Wandler 214 mit einer Auflösung von 8 bit und einer Einschwingzeit von 100 ns generiert. Der Digital/Analog-Wandler stellt das von einem Rechner 212, insbesondere einem Mikrocontroller bereitgestellte Prüfsignal in analoger Form für den Ausgang 220 des Prüfgerätes 200 bereit. Eine bevorzugte Refresh-Rate liegt bei beispielsweise 100 k samples. Der Rechner ist, gegebenenfalls mit einer geeigneten Software ausgebildet, um das Prüfsignal in nahezu beliebigen Signalformen insbesondere jedoch als Sinus, Dreieck oder Puls-Signal auszubilden. Die Amplitude, Frequenz und Phase des Prüfsignals sind ebenfalls frei wählbar. Um die Auflösung bei niedrigen Signalamplituden zu verbessern, ist die maximale Amplitude des Prüfsignals vorzugsweise mit einem weiteren Digital/Analog-Wandler (nicht gezeigt) einstellbar. Zur Gewährleistung einer hohen Signalgüte wird vorzugsweise ein Bereichsabschwächer sowie ein Tiefpassfilter, insbesondere ein Glitsch-Filter verwendet. Diese beiden Einrichtungen dienen zum Verrunden der von dem DA-Wandler ausgegebenen Treppenstufen innerhalb des Prüfsignals. Der Y-Bereich des Signalgenerators ist vorzugsweise umschaltbar, bei bipolaren Prüfsignalen bis +/- 10 V, bei unipolaren Prüfsignalen beispielsweise bis 12 V, mit einer Strombegrenzung von bspw. 50 mA.

Um das Verhalten der zu prüfenden elektrischen Komponente bei mindestens einer elektrischen Belastung prüfen zu können, umfasst das Prüfgerät vorteilhafterweise alternativ oder zusätzlich zu dem Signalgenerator eine vorzugsweise von dem Rechner 212 variabel einstellbare Impedanz 260. Sie dient insbesondere zum Anschluss an den Ausgang der zu prüfenden elektrischen Komponente.

Nachfolgend werden verschiedene Anwendungsbeispiele für das erfindungsgemäße Prüfgerät aufgezeigt.

Bei den ersten beiden Anwendungsbeispielen wird der in Figur 1 dargestellte Schaltkreis entweder an der Anschlussstelle 160-1 oder an der Anschlussstelle 160-2 aufgetrennt, um jeweils die Sensoreinrichtung 110 abzutrennen und ein von dem Prüfgerät 200 bereitgestelltes geeignetes Prüfsignal in den rechten Teil der Schaltung gemäß Figur 1, das heißt in die Komponenten 120 - 150 einzuspeisen. Das eingespeiste Prüfsignal ist dann vorzugsweise als typisches Eingangssignal für die Komponente 130 in einem vorbestimmten Betriebszustand ausgebildet. Anders ausgedrückt simuliert das Prüfsignal bei den ersten beiden Ausführungsbeispielen das Verhalten der dem Steuergerät 130 vorgeschalteten Sensoreinrichtung 110, indem es vorzugsweise deren typisches Ausgangssignal, das heißt das Messsignal nachbildet. Mit der Einspeisung des Prüfsignals soll grundsätzlich die Funktionsfähigkeit der der aufgetrennten Anschlussstelle nachgeschalteten Komponenten des Schaltkreises 100 überprüft werden. Dieses Verhalten kann je nach Ausbildung der Komponenten 130 oder 150 entweder akustisch oder per Eigendiagnose oder mittels eines Messgerätes wahrgenommen werden. Entspricht das wahrgenommene Verhalten einer Komponente nicht den Erwartungen, so lässt dies auf eine Fehlerhaftigkeit der entsprechenden Komponente schließen. Ist das Verhalten aller der auftrennten Anschlussstelle nachgeschalteten Komponenten 120 - 150 jedoch fehlerfrei und zeigt der Schaltkreis 100 bei angeschlossener Sensoreinrichtung 110 dennoch ein Fehlverhalten, so lässt diese Erkenntnis einen Rückschluss auf eine Fehlerhaftigkeit der Sensoreinrichtung 110 zu.

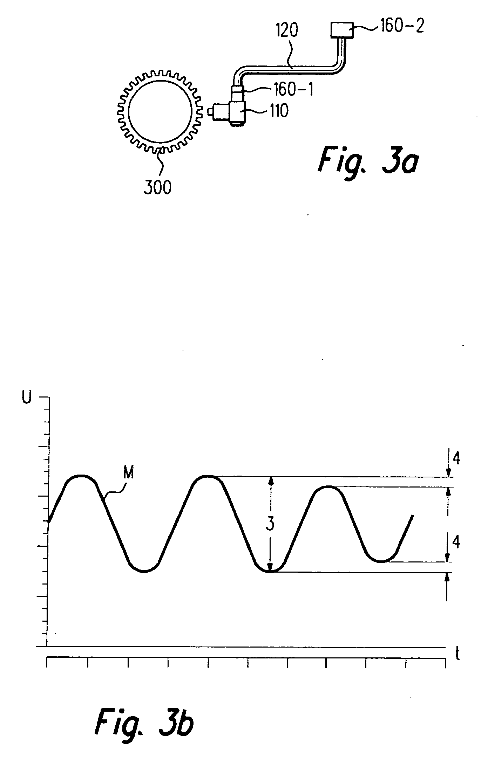

In einem ersten Anwendungsbeispiel wird angenommen, dass es sich bei der Sensoreinrichtung 110 um einen Radsensor zum Erfassen der Winkelgeschwindigkeit eines Rades 300 handelt, wie dies in Figur 3a dargestellt ist. In diesem Fall wird das Prüfsignal von dem Prüfgerät 200 beziehungsweise dem Signalgenerator 210 in der Weise ausgebildet, dass es das typische Ausgangssignal des Radsensors repräsentiert. Das Prüfsignal wird vorteilhafterweise an der Anschlussstelle 160-1 nach rechts in den in Figur 1 dargestellten Schaltkreis eingespeist, wobei angenommen wird, dass die Komponente 130 ein Steuergerät repräsentiert. Während das Prüfsignal anliegt, kann die Eigendiagnose des Steuergerätes 130 zum Beispiel permanent ausgelesen und dahingehend kontrolliert werden, ob das Steuergerät 130 das Prüfsignal überhaupt und wenn ja richtig empfängt. Wenn dies der Fall ist, so lässt dies auf einen ordnungsgemäßen Zustand der Kabelverbindung 120 und des Steuergerätes 130 schließen.

Bei einem zweiten Anwendungsbeispiel wird davon ausgegangen, dass es sich bei der Sensoreinrichtung 110 um einen Temperaturfühler handelt. In diesem Fall ist das Prüfsignal so ausgebildet, dass es typische Ausgangssignale des Temperaturfühlers bei unterschiedlichen Temperaturbereichen nachbildet; dafür wird das Prüfsignal in geeigneter Weise variiert. Wird nun das Prüfsignal entweder an der Anschlussstelle 160-1 oder an der Anschlussstelle 160-2 in das Steuergerät 130 eingespeist, so lassen sich auf diese Weise verschiedene Ausgangssignale des Temperaturfühlers am Eingang des Steuergerätes simulieren. Auf diese Weise kann die Reaktion des Steuergerätes auf erfolgte Temperaturwechsel überprüft werden. Dies ist zum Beispiel bei Kraftfahrzeugen mit Dieselantrieb von Bedeutung, bei denen das Steuergerät aufgrund des von dem Temperaturfühler bereitgestellten Messgerätes tiefe Temperaturen erkennen und eventuell eine Vorglühanlage aktivieren muss. Bei Kraftfahrzeugen mit Otto-Motor kann es zum Beispiel erforderlich sein, dass das Steuergerät beim Erkennen tiefer Temperaturen ein Sekundärluftsystem aktivieren muss oder generell kann es erforderlich sein, dass das Steuergerät bei Vorliegen hoher Temperaturen einen Kühlerlüfter aktivieren muss.

Wenn bereits ein konkreter Verdacht vorliegt, dass vermutlich das Stellglied 150 defekt sein wird, ist es empfehlenswert, das Prüfsignal nicht an den Anschlussstellen 160-1 oder 160-2, sondern an der Anschlussstelle 160-4 in das Stellglied 150 einzuspeisen. Das Prüfsignal repräsentiert dann vorzugsweise das typischerweise von dem Steuergerät 130 ausgegebene Stellsignal zur Ansteuerung des Stellglieds 150. Auf diese Weise kann die Reaktion des Stellglieds einer genauen Prüfung unterzogen werden. Dies gilt generell, unabhängig davon, ob das Stellglied 150 noch in dem Kraftfahrzeug eingebaut ist oder nicht.

Bei einem dritten Anwendungsbeispiel wird angenommen, dass es sich bei dem Stellglied 150 um ein Ladedruckventil handelt. Durch Ansteuern dieses Ladedruckventils mit einem geeigneten Prüfsignal kann die Funktion eines Turboladers des Kraftfahrzeugs überprüft werden. Dazu wird das Prüfsignal als unipolares Prüfsignal einer Amplitude von 12 V mit einer modulierten Pulsweite ausgebildet. Wird das so ausgebildete Prüfsignal in das Ladedruckventil eingespeist und wird gleichzeitig die Brennkraftmaschine betrieben, so muss sich bei fehlerfreiem Turbolader im Saugrohr der Brennkraftmaschine ein Druck einstellen, der im Ansprechen auf die Modulation des Prüfsignals bis zu einem vorbestimmten begrenzten Sicherheitsdruck des Turboladers ansteigt.

Gemäß einem vierten Anwendungsbeispiel kann das beschriebene Prüfgerät 200 dazu verwendet werden, die Funktionsfähigkeit eines Abgasrückführungssystems des Kraftfahrzeugs auf seine Funktionsfähigkeit hin zu überprüfen. Dazu wird ein elektropneumatischer Druckwandler des Abgasrückführungssystems, welcher das Stellglied 150 in Figur 1 repräsentiert, mit einem pulsweitenmodulierten Prüfsignal beaufschlagt. Eine ordnungsgemäße Funktionsweise des Abgasrückführungssystems zeigt sich dann in einer Veränderung des Ventilhubs des Abgasrückführungssystems, einer Veränderung des Motorlaufs oder einer Veränderung im Abgas, jeweils im Ansprechen auf das modulierte Prüfsignal. Entsprechen die festgestellten Änderungen den Erwartungen, so arbeitet das Abgasrückführungssystem fehlerfrei; anderenfalls tut es dies nicht.

Ein fünftes Anwendungsbeispiel der Erfindung sieht vor, mit Hilfe des Prüfgerätes 200 die Funktionsfähigkeit eines Tankentlüftungsventils als Stellglied 150 zu überprüfen. Zu diesem Zweck wird vorgeschlagen, das Tankentlüftungsventil mit einem pulsweitenmodulierten Prüfsignal zu speisen. Die ordnungsgemäße Funktion des Tankentlüftungsventils lässt sich akustisch durch Klappern des Ventils wahrnehmen. Ist diese akustische Reaktion nicht zu vernehmen, so deutet dies auf einen Defekt des Tankentlüftungsventils hin. Durch Anlegen eines Prüfsignals in Form eines Druckes beziehungsweise eines Unterdruckes an das Tankentlüftungsventil kann zusätzlich dessen mechanische Funktion "Öffnen" beziehungsweise "Schließen" kontrolliert werden.

In den Figuren 3a und 3b ist schließlich ein fünftes Anwendungsbeispiel für das Prüfgerät 200 veranschaulicht. Figur 3a zeigt eine als Drehzahlsensor ausgebildete Sensoreinrichtung 110. Sie dient zum Erfassen der Winkelgeschwindigkeit eines Rades 300. Der Drehzahlsensor erzeugt ein Messsignal M, welches er über die Kabelverbindung 120 an die Anschlussstelle 160-2 ausgibt. Zum Überprüfen der Funktionsfähigkeit des Drehzahlsensors wird diese Anschlussstelle 160-2 an den Eingang 250 des Prüfgerätes 200 angeschlossen. Außerdem wird dann, wenn die Mess- und Anzeigeeinrichtung 240 lediglich einkanalig ausgebildet ist, ein Schalter S innerhalb des Prüfgerätes 200 so eingestellt, dass der Eingang 250 des Prüfgerätes auf den Eingang der Mess- und Anzeigeeinrichtung 240 geleitet wird. Diese veranschaulicht den Verlauf des Messsignals wie der beispielsweise in Figur 3b dargestellt ist. Das Messsignal kann dann hinsichtlich seiner maximalen Amplitude 3 oder hinsichtlich auftretender Amplitudenschwankungen 4 ausgewertet werden. Liegen beispielsweise diese Amplitudenschwankungen 4 außerhalb eines Toleranzbereiches oder fehlen ganze Amplituden oder pulsieren vorhandene Amplituden, so lässt dies bei gegebenem gleichmäßigen Umlauf des Rades 300 auf eine Fehlerhaftigkeit des Drehsensors schließen.

## Patentansprüche

1. Prüfgerät (200), insbesondere für Kfz-Werkstätten, zum Prüfen der Funktionsfähigkeit einer Komponente eines Kfz, **gekennzeichnet durch** einen Signalgenerator (210) zum Bereitstellen von mindestens einem Prüfsignal als Eingangssignal für die zu prüfende Komponente; und/oder eine vorzugsweise variabel einstellbare Impedanz zum Belasten der zu prüfenden Komponente.

2. Prüfgerät (200) nach Anspruch 1, **dadurch gekennzeichnet, dass** der Signalgenerator (210) ausgebildet ist, das Prüfsignal als typisches Eingangssignal für die zu prüfende Komponente in einem vorbestimmten Betriebszustand auszubilden.

3. Prüfgerät (200) nach Anspruch 2, **dadurch gekennzeichnet, dass** der Signalgenerator (210) ausgebildet ist, das Prüfsignal so zu generieren, dass es das Ausgangssignal einer der zu prüfenden Komponente üblicherweise vorgeschalteten Komponente, insbesondere einer Sensoreinrichtung oder eines Steuergerätes, repräsentiert.

4. Prüfgerät (200) nach Anspruch 3, **gekennzeichnet durch** eine Speichereinrichtung (218), insbesondere eine Datenbank, zum Speichern von mindestens jeweils einem derartigen Ausgangssignal für eine Vielzahl unterschiedlicher Komponenten.

5. Prüfgerät (200) nach Anspruch 4, **dadurch gekennzeichnet, dass** der Signalgenerator (210) eine Schnittstelle oder einen Messkanaleingang (216) aufweist zum Erfassen von extern bereitgestellten Soll-Signalen und ausgebildet ist zum Speichern der Soll-Signale in der Speichereinrichtung (218) und zum Ausgeben der Soll-Signale als das Prüfsignal.

6. Prüfgerät (200) nach Anspruch 1, **dadurch gekennzeichnet, dass** der Signalgenerator (210) ausgebildet ist, das Prüfsignal als Fehlersignal in Form eines atypischen Eingangssignals für die zu prüfende Komponente auszubilden.

7. Prüfgerät (200) nach einem der vorangegangenen Ansprüche, **dadurch gekennzeichnet, dass** der Signalgenerator (210) ausgebildet ist, das Prüfsignal in seiner Signalform, insbesondere ob es als Sinus, Dreieck oder Rechtecksignal ausgebildet ist, und/oder hinsichtlich seiner Amplitude, Frequenz, Phase oder Pulsweite zu variieren.

8. Prüfgerät (200) nach einem der vorangegangenen Ansprüche, **dadurch gekennzeichnet, dass** der Signalgenerator (210) ausgebildet ist, das Prüfsignal als elektrisches Signal, als hydraulisches oder pneumatisches Drucksignal, als Temperatursignal und/oder als Feuchtesignal auszubilden.

9. Prüfgerät (200) nach einem der vorangegangenen Ansprüche, **dadurch gekennzeichnet, dass** der Signalgenerator (210) kurzschlussfest und/oder bezüglich der Höhe seines Ausgangsstroms begrenzbar ausgebildet ist.

10. Prüfgerät (200) nach einem der vorangegangenen Ansprüche, **gekennzeichnet durch** einen zwischen den Ausgang des Signalgenerators (210) und den Ausgang des Prüfgerätes (220) geschalteten Power-Generator (230) zum Bereitstellen des von dem Signalgenerator (210) generierten Prüfsignals mit einem in seiner Höhe an die Leistungsaufnahme der zu prüfenden Komponente angepassten Ausgangsstrom.

11. Prüfgerät (200) nach einem der vorangegangenen Ansprüche, **gekennzeichnet durch** eine Mess- und/oder Anzeigeeinrichtung (240), insbesondere ein Oszilloskop, zum Messen/Anzeigen des Prüfsignals und/oder zum Messen/Anzeigen einer elektrischen Ausgangsgröße von insbesondere der zu prüfenden Komponente.
